# EUROPEAN PATENT SPECIFICATION

(11) **EP 2 792 045 B1**
(45) Date of publication and mention of the grant of the patent: **15.02.2017**
(21) Application number: 12813445.9
(22) Date of filing: 04.12.2012
(51) Int. Cl.: H02J 7/00, H02M 3/00

(54) **PROCEDURE FOR THE MANUFACTURE OF BATTERY CHARGERS FOR VEHICLES AND BATTERY CHARGERS THUS OBTAINABLE**
VERFAHREN ZUR HERSTELLUNG VON BATTERIELADEVORRICHTUNGEN FÜR FAHRZEUGE UND IN DIESEM VERFAHREN HERGESTELLTE BATTERIELADEVORRICHTUNGEN
PROCÉDÉ POUR LA FABRICATION DE CHARGEURS DE BATTERIE POUR VÉHICULES ET CHARGEURS DE BATTERIE POUVANT ÊTRE OBTENUS AINSI

(30) Priority: 15.12.2011 IT MO20110325
(43) Date of publication of application: 22.10.2014
(73) Proprietor: Meta System S.p.A., 42124 Reggio Emilia (IT)
(72) Inventor: LASAGNI, Cesare, I-42123 Reggio Emilia (IT); SIMONAZZI, Giuseppe, I -42123 Reggio Emilia (IT)
(74) Representative: Grana, Daniele
(86) International application number: PCT/IB2012/002594
(87) International publication number: WO 2013/088217

(56) References cited:
- GB-A- 2 336 254
- US-A1- 2005 052 888
- US-A1- 2005 083 665
- US-A1- 2008 150 623
- US-A1- 2010 277 121

## Description

### Technical Field

The present invention relates to a procedure for the manufacture of battery chargers for vehicles and battery chargers thus obtainable.

### Background Art

It is known that battery chargers for vehicles generally comprise a printed circuit connectable to the battery of a vehicle, made on a support in electrically insulating material such as vetronite or on a metal support of the IMS (Insulated Metal Substrate) type.

It is underlined in particular that in the field of the manufacture of battery chargers for vehicles, the use of printed circuits with metal support is preferred because it permits achieving high thermal efficiency, due precisely to the heat dissipation characteristics of the metal used (generally aluminium).

It is further known that the battery chargers of known type generally comprise a further module, separated from the printed circuit, made up of a support for housing all the large-size wound electrical components (for powers in the region of kWs) made up of components such as transformers, filters and inductances. Such further module is necessary because the wound components, precisely because they are of large size, are difficult to fix directly to the printed circuit. With particular reference to the printed circuit with support in vetronite, in fact, the fixing of the wound components directly on the support would result in the printed circuit having low mechanical sturdiness, thus negatively and substantially affecting the life of the battery charger.

Furthermore, with reference to the use of a printed circuit with IMS type metal support, to the problem of low mechanical sturdiness must be added the fact that the fixing of the wound components on the support would require drilling the support itself, with the consequent high risk of electrical short circuits.

It is in fact known that IMS type supports comprise a metal plate, commonly made of aluminium, covered with a thin layer of dielectric material on which the copper tracks are made.

Consequently, drilling the support to fix a wound component would mean making a possible power connection between the wound component itself and the aluminium of the support, thereby creating a short circuit.

In the battery chargers of known type, therefore, the module with the wound electric components is connected to the printed circuit by means of specific power cables and both are fixed inside a specific box or in different boxes.

The document US 2005/083665 A1 discloses a power conversion module device comprising a transformer, a primary power element and a secondary power element mounted on a printed wiring board in surface-to-surface contact therewith. The document US 2008/150623 A1 discloses a semiconductor chip structure and its application circuit network, wherein the switching voltage regulator or converter is integrated with a semiconductor chip by chip fabrication method, so that the semiconductor chip has the ability to regulate voltage within a specific voltage range.

### Description of the Invention

The main aim of the present invention is to provide a procedure for the manufacture of battery chargers for vehicles which permits the manufacture of a battery charger for vehicles of smaller dimensions and with high mechanical sturdiness.

Another object of the present invention is to provide a procedure for the manufacture of battery chargers for vehicles which permits the manufacture of a battery charger with high thermal efficiency.

Another object of the present invention is to provide a procedure for the manufacture of battery chargers for vehicles and a battery charger thus obtainable which allow to overcome the mentioned drawbacks of the state of the art in the ambit of a simple, rational, easy and effective to use as well as low cost solution.

The above objects are achieved by the present procedure for the manufacture of battery chargers for vehicles, comprising a stage of manufacturing at least an electronic circuit connectable to the battery of a vehicle and suitable for charging said battery, said electronic circuit having at least a printed circuit and at least a wound component electronically connected to said printed circuit, characterized by the fact that said stage of manufacturing comprises the steps of:
- fixing said wound component to said printed circuit;
- depositing a heat hardening material onto at least one portion of said printed circuit in correspondence to said wound component;
- solidifying said heat hardening material for the blocking of said wound component on said printed circuit.

The above objects are also achieved by the present battery charger for vehicles, comprising at least an electronic circuit connectable to the battery of a vehicle and suitable for charging said battery, said electronic circuit having at least one printed circuit and at least one wound component electronically connected to said printed circuit, characterized by the fact that said wound component is fixed to said printed circuit and by the fact that said electronic circuit comprises at least a layer of solidified heat hardening material deposited onto at least a portion of said printed circuit and in correspondence to said wound component for the blocking of said wound component on said printed circuit.

### Brief Description of the Drawings

Other characteristics and advantages of the present invention will become more evident from the description of a preferred, but not sole, embodiment of a procedure for the manufacture of battery chargers for vehicles and a battery charger thus obtainable, illustrated purely as an example but not limited to the annexed drawings in which:

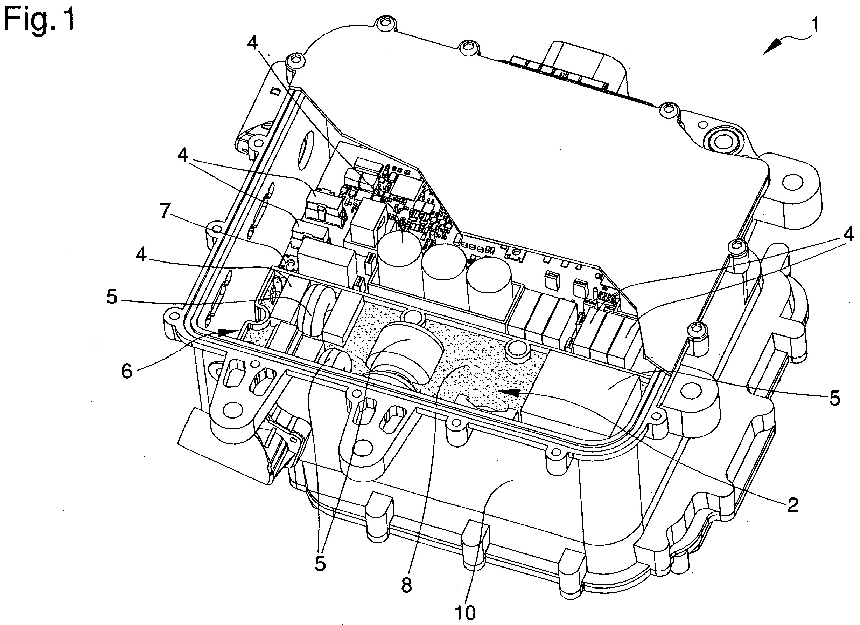

Figure 1 is an axonometric and partial section view of the battery charger according to the invention;
Figures from 2 to 8 show different steps of the procedure according to the invention.

### Embodiments of the Invention

With particular reference to figure 1, globally indicated by 1 is a battery charger for vehicles, usable in particular for recharging batteries of electric vehicles. The battery charger 1 comprises an electronic circuit, indicated altogether in figure 1 by the reference 2, connectable to the battery of a vehicle and suitable for recharging the battery itself.

In particular, the electronic circuit 2 comprises:
- a printed circuit 3;
- a plurality of electronic components 4 suitable for processing the supply voltages and currents and made up, e.g., of electronic power components, condensers, etc.;
- a plurality of wound components 5 made up, e.g., of components such as transformers, filters and inductances.

In particular, the wound components 5 are large-size components usable for powers in the region of kWs.

The electronic components 4 are fixed to the printed circuit 3 and are connected electronically to the conductive tracks of the printed circuit itself. Advantageously, the wound components 5 are also directly fixed to the printed circuit 3 and are electronically connected to the conductive tracks of the printed circuit itself.

Consequently, in a different way compared to the state of the art, where the large-size wound components are housed inside a separate module and connected to the printed circuit by means of specific electric cables, in the battery charger 1 according to the present invention, the large-size wound components 5 are arranged and fixed directly to the printed circuit 3.

The electronic circuit 2 also comprises a template 6 anchored to the printed circuit 3 and having an outer retention wall 7 which surrounds the portion of the printed circuit on which the wound components 5 are fixed.

Advantageously, the electronic circuit 2 comprises a layer of solidified heat hardening material 8 deposited on the entire area of the printed circuit 3 delimitated by the template 6 and suitable for allowing the securing of the wound components 5 on the printed circuit itself.

In practice therefore, the layer of solidified heat hardening material 8 permits achieving a greater mechanical sturdiness of the electronic circuit 2, ensuring the securing of the large-size wound components 5 directly on the printed circuit 3.

Usefully, the layer of hardening material 8 also permits a uniform and efficient dispersion of the heat generated by the wound components 5 during normal operation.

Usefully, the heat hardening material 8 can be made up of a resin or of a like material.

The printed circuit 3 can be made using techniques of known type on a support in dielectric material of the vetronite type or like electrically insulating material. Alternatively, a preferred embodiment of the battery charger 1 contemplates the realization and the use of a printed circuit of the IMS (Insulated Metal Substrate) type.

In this case, therefore, the printed circuit 3 comprises a support in metal material, preferably aluminium, on which is deposited a dielectric layer.

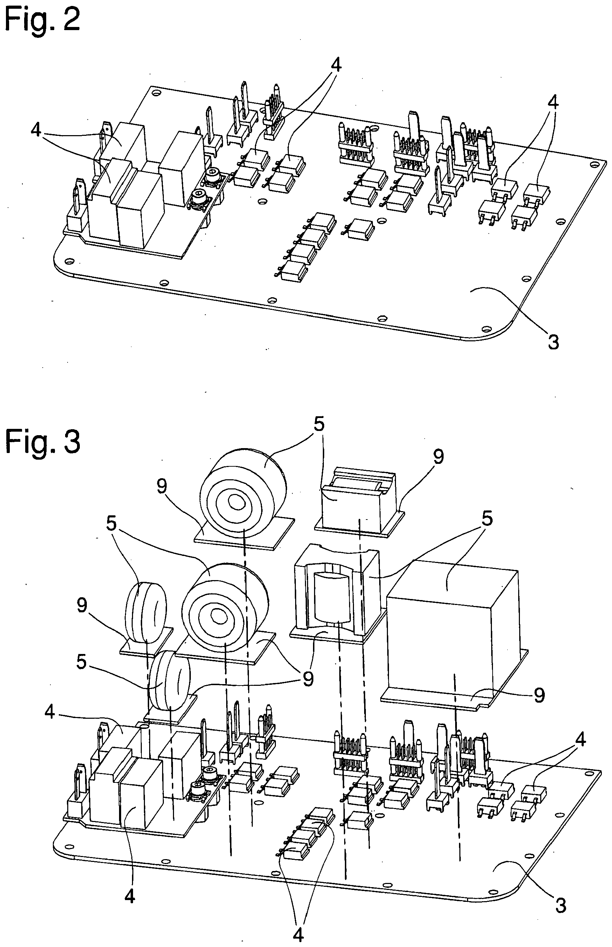

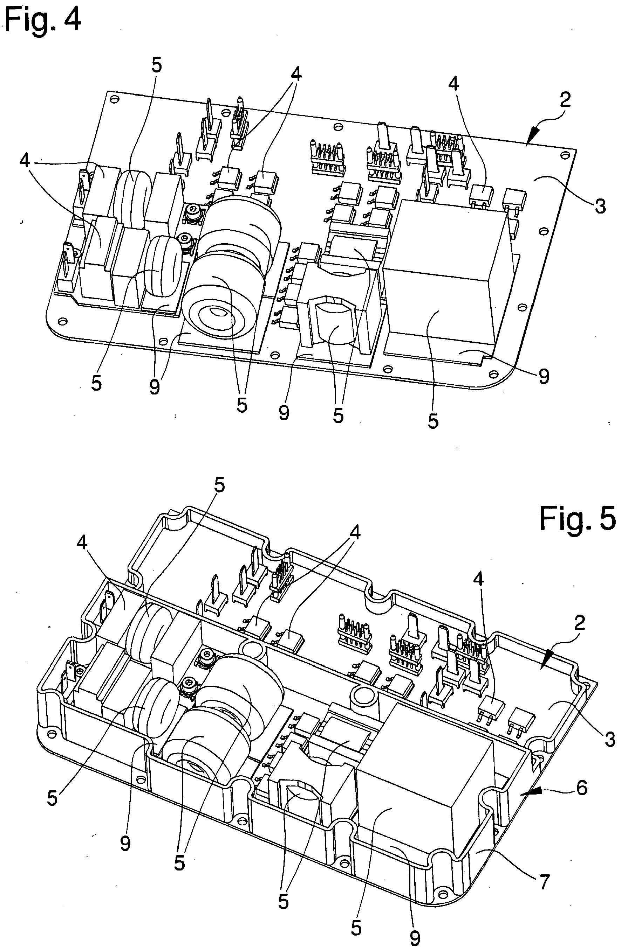

As shown in particular in the figures 3 and 4, in the case of the use of a printed circuit 3 of the IMS type, the electronic circuit 2 comprises a plurality of supports 9 in dielectric material.

To each of the supports 9 is fixed a corresponding wound component 5.

In turn, each of the supports 9 is fixed to the support of the printed circuit 3. The supports 9 are preferably plate-shaped and have an upper face suitable for accommodating the respective wound component 5 and a lower face associable integral with the printed circuit 3.

Different conformations of the supports 9 cannot however be ruled out. Advantageously, the use of the supports 9 allows fixing the wound components 5 to the printed circuit 3 with the metal support without the risk of power connection between the wound components and the printed circuit themselves. Consequently, the use of the supports 9 allows avoiding undesired short-circuits.

This way, the use of a printed circuit 3 of the IMS type, together with the fixing of the wound components 5 to the printed circuit itself by means of the supports 9, allows obtaining a battery charger of reduced dimensions and with high thermal efficiency, at the same time simplifying the fitting of the wound components themselves.

The printed circuit 3 of the IMS type, in particular the metal support, does in fact allow considerably improving the dispersion of the heat produced during the use of the battery charger 1.

Usefully, each of the supports 9 can comprise electronic means of connection between the respective wound component 5 and the printed circuit 3.

In particular, each of the supports 9 can be made up in turn of a printed circuit, wherein the electronic means of connection are made up of suitable conductive tracks and/or suitable terminals on the support which electronically connect the wound component 5 to the printed circuit 3.

Furthermore, the battery charger 1 comprises a box 10 for housing and protecting the electronic circuit 2.

The procedure for the manufacture of the battery charger 1 is described below. The procedure comprises the manufacture of the electronic circuit 2 connectable to the battery of a vehicle and suitable for charging the battery.

In particular, the procedure comprises:
- manufacturing the printed circuit 3;
- fixing to the printed circuit electronic components 4 suitable for processing the supply voltages and currents and made up, e.g., of electronic power components, condensers or the like;
- the electronic connection of the electronic components 4 to the conductive tracks of the printed circuit.

The printed circuit 3 with the electronic components 4 is shown by way of example in figure 2.

Advantageously, the procedure according to the invention comprises the fixing of the large-size wound components, such as transformers, filters and inductances, directly to the printed circuit 3.

In particular, with reference to a preferred but not exclusive embodiment and as shown schematically in the figures 3 and 4, in the case of the use of a printed circuit 3 of the IMS type with metal support, the fixing of the wound components 5 to the printed circuit comprises:
- fixing each wound component 5 to a respective support 9 in dielectric material;
- fixing the support 9 to the printed circuit 3.

The procedure according to the invention further comprises the electronic connection of the wound components 5 to the conductive tracks of the printed circuit 3.

Usefully, for this purpose, each of the supports 9 can have electronic means of connection, not shown in the illustrations.

In particular, each of the supports 9 can in turn be made up of a printed circuit, wherein the electronic means of connection are made up of suitable conductive tracks and/or suitable terminals on the support, electronically connecting the wound component 5 to the printed circuit 3.

In this case, the procedure comprises:
- the connection of the wound component 5 to the electronic means of connection of the support 9;
the connection of the electronic means of connection of the support 9 to the printed circuit.

Advantageously, as shown in figure 5, the procedure comprises the anchoring of a template 6 to the printed circuit 3.

In particular, the template 6 has the outer retention wall 7 which surrounds an area of the printed circuit 3 wherein the wound components 5 are fixed.

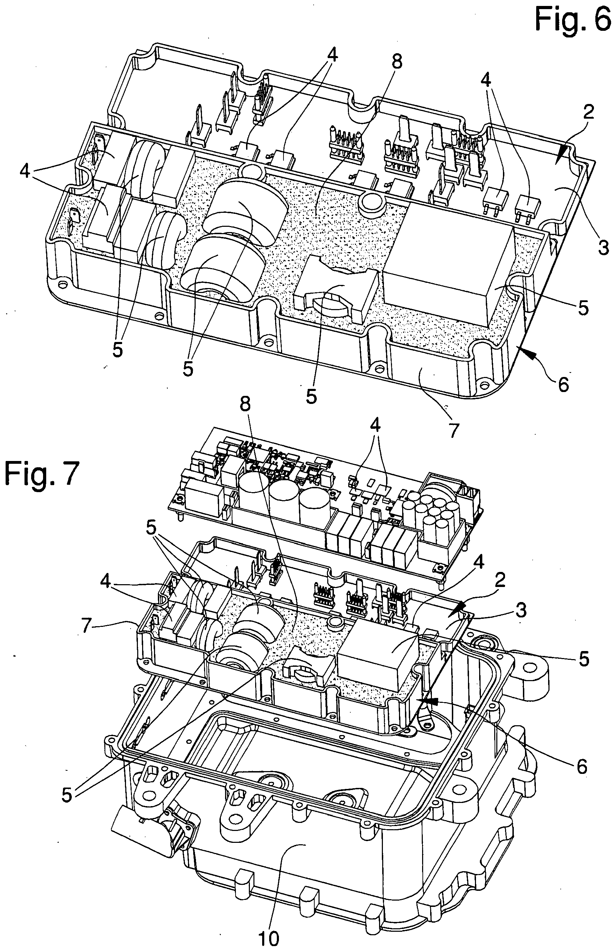

As shown in figure 6, the procedure comprises depositing a layer of heat hardening material 8 on the printed circuit 3 in correspondence to the wound components 5.

The heat hardening material 8 is preferably made of a resin or a like material.

In particular, the heat hardening material 8 is deposited in such a way as to cover the entire area of the printed circuit 3 delimited by the outer wall 7 of the template 6.

Consequently, the template 6 performs the function of containing the heat hardening material 8 still not solidified inside the predetermined area of the printed circuit 3.

The procedure subsequently comprises the solidification of the heat hardening material 8 for securing the wound components 5 on the printed circuit 3.

In practice therefore, the layer of solidified heat hardening material 8 allows reaching a greater mechanical sturdiness of the electronic circuit 2, ensuring the securing of the large-size wound components 5 directly on the printed circuit 3. Usefully, furthermore, the layer of hardening material 8 allows a uniform and efficient dispersion of the heat produced by the wound components 5 during normal operation.

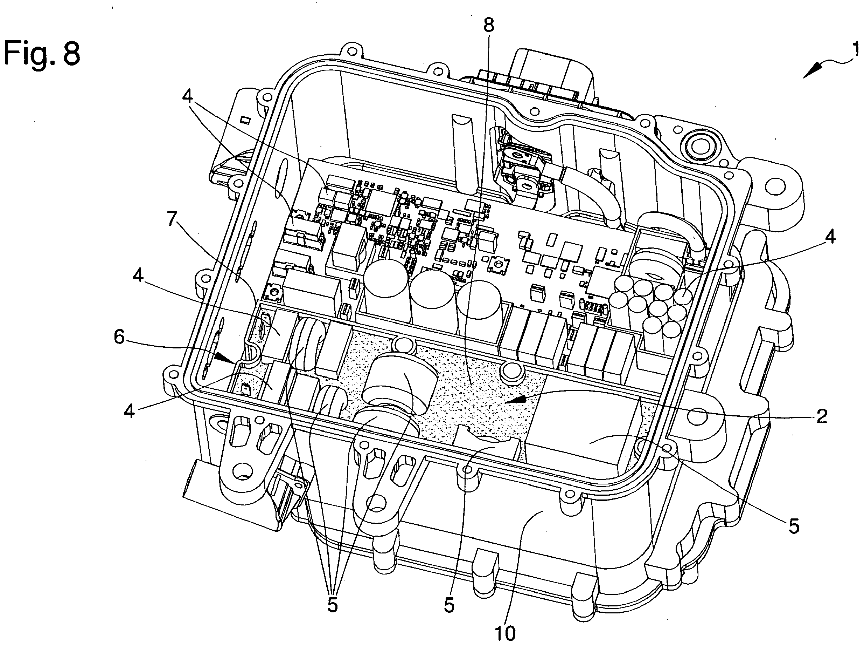

Finally, as shown schematically in the figures 7 and 8, the electronic circuit 2 made this way is arranged and fixed inside the protection box 10 and is connected to suitable input and output connectors.

It has in point of fact been ascertained how the described invention achieves the proposed objects.

## Claims

1. Procedure for the manufacture of battery chargers for vehicles, comprising a stage of manufacturing at least an electronic circuit (2) connectable to the battery of a vehicle and suitable for charging said battery, said electronic circuit (2) having at least a printed circuit (3) and at least a wound component (5) electronically connected to said printed circuit (3), said stage of manufacturing comprises the steps of:
- fixing said wound component (5) to said printed circuit (3);
- anchoring at least one template (6) to said printed circuit (3), said template (6) having at least an outer retention wall (7) which extends at least in part around said wound component (5);
- depositing a heat hardening material (8) onto the entire area of said printed circuit (3) delimited by said outer wall (7) of the template (6), in correspondence to said wound component (5);
- solidifying said heat hardening material (8) for the blocking of said wound component (5) on said printed circuit (3).

2. Procedure according to claim 1, **characterized by** the fact that said stage of manufacturing comprises the step of fixing a plurality of wound components to said printed circuit (3) and by the fact that said outer wall (7) of the template (6) surrounds said plurality of wound components.

3. Procedure according to one or more of the preceding claims, **characterized by** the fact that said heat hardening material (8) is of the resin type or the like.

4. Procedure according to one or more of the preceding claims, **characterized by** the fact that said printed circuit (3) comprises at least a support made of dielectric material.

5. Procedure according to one or more of the preceding claims, **characterized by** the fact that said printed circuit (3) comprises at least a support made of metal material.

6. Procedure according to one or more of the preceding claims, **characterised by** the fact that said step of fixing comprises the steps of:
- fixing said wound component (5) to at least a support (9) made of dielectric material;
- fixing said support (9) to said printed circuit (3).

7. Procedure according to claim 6, **characterised by** the fact that said support (9) made of dielectric material comprises electronic means of connection between said wound component (5) and said printed circuit (3) and by the fact that said step of connecting comprises:
- after said step of fixing said wound component (5) to said support (9), a step of electronically connecting said wound component (5) to said electronic means of connection of the support (9);
- after said step of fixing said support (9) to said printed support (3), a step of electronically connecting said electronic means of connection of the support (9) to said printed circuit (3).

8. Procedure according to one or more of the preceding claims, **characterized by** the fact that it comprises the step of arranging said electronic circuit (2) inside a protection box (10).

9. Battery charger (1) for vehicles, comprising at least an electronic circuit (2) connectable to the battery of a vehicle and suitable for charging said battery, said electronic circuit (2) having at least one printed circuit (3) and at least one wound component (5) electronically connected to said printed circuit (3),
- said wound component (5) is fixed to said printed circuit (3);
- said electronic circuit (2) comprises at least a template (6) anchored to said printed circuit (3), said template (6) having at least an outer retention wall (7) which extends at least in part around said wound component (5);
- and said electronic circuit (2) comprises at least a layer of solidified heat hardening material (8) that covers the entire area of said printed circuit (3) delimited by said outer wall (7) of the template (6), in correspondence to said wound component (5), for the blocking of said wound component (5) on said printed circuit (3).

10. Battery charger (1) according to claim 9, **characterized by** the fact that said electronic circuit (2) comprises a plurality of wound components fixed to said printed circuit (3) and by the fact that said outer wall (7) of the template (6) surrounds said plurality of wound components.

11. Battery charger (1) according to one or more of claims 9 and 10, **characterized by** the fact that said printed circuit (3) comprises at least one support made of dielectric material and/or one support made of metal material.

12. Battery charger (1) according to one or more of claims from 9 to 11, **characterized by** the fact that said electronic circuit (2) comprises at least a support (9) made of dielectric material, said wound component (5) being fixed to said support (9) and said support (9) being fixed to said printed circuit (3).

13. Battery charger (1) according to the claim 12, **characterized by** the fact that said support (9) made of dielectric material comprises electronic means of connection between said wound component (5) and said printed circuit (3).

## Patentansprüche

1. Verfahren zur Herstellung von Batterieladevorrichtungen für Fahrzeuge, mit einer Stufe des Herstellens wenigstens einer elektronischen Schaltung (2), die an die Batterie eines Fahrzeugs angeschlossen werden kann und zum Laden der Batterie geeignet ist, wobei die elektronische Schaltung (2) wenigstens eine gedruckte Schaltung (3) und wenigstens eine mit der gedruckten Schaltung (3) elektronisch verbundene Wickelkomponente (5) aufweist, wobei die Stufe des Herstellens die Schritte umfasst:
- Befestigen der Wickelkomponente (5) an der gedruckten Schaltung (3);
- Verankern wenigstens einer Schablone (6) an der gedruckten Schaltung (3), wobei die Schablone (6) wenigstens eine äußere Haltewand (7) aufweist, welche sich wenigstens teilweise um die Wickelkomponente (5) herum erstreckt;
- Ablagern eines warmhärtenden Materials (8) auf dem gesamten Bereich der gedruckten Schaltung (3), der in Übereinstimmung mit der Wickelkomponente (5) durch die Außenwand (7) der Schablone (6) begrenzt ist;
- Verfestigen des warmhärtenden Materials (8), um die Wickelkomponente (5) auf der gedruckten Schaltung (3) zu blockieren.

2. Verfahren nach Anspruch 1, **dadurch gekennzeichnet, dass** die Stufe des Herstellens den Schritt des Befestigens einer Mehrzahl von Wickelkomponenten an der gedruckten Schaltung (3) umfasst, und dadurch, dass die Außenwand (7) der Schablone (6) die Mehrzahl von Wickelkomponenten umgibt.

3. Verfahren nach einem oder mehreren der vorhergehenden Ansprüche, **dadurch gekennzeichnet, dass** das warmhärtende Material (8) vom Typ her ein Harz oder dergleichen ist.

4. Verfahren nach einem oder mehreren der vorhergehenden Ansprüche, **dadurch gekennzeichnet, dass** die gedruckte Schaltung (3) wenigstens einen Träger aus dielektrischem Material umfasst.

5. Verfahren nach einem oder mehreren der vorhergehenden Ansprüche, **dadurch gekennzeichnet, dass** die gedruckte Schaltung (3) wenigstens einen Träger aus Metall-Material umfasst.

6. Verfahren nach einem oder mehreren der vorhergehenden Ansprüche, **dadurch gekennzeichnet, dass** der Schritt des Befestigens die Schritte umfasst:
- Befestigen der Wickelkomponente (5) an wenigstens einem Träger (9) aus dielektrischem Material;
- Befestigen des Trägers (9) an der gedruckten Schaltung (3).

7. Verfahren nach Anspruch 6, **dadurch gekennzeichnet, dass** der Träger (9) aus dielektrischem Material elektronische Verbindungsmittel zwischen der Wickelkomponente (5) und der gedruckten Schaltung (3) umfasst, und dadurch, dass der Schritt des Verbindens umfasst:
- nach dem Schritt des Befestigens der Wickelkomponente (5) an dem Träger (9), einen Schritt des elektronischen Verbindens der Wickelkomponente (5) mit dem elektronischen Verbindungsmittel des Trägers (9);
- nach dem Schritt des Befestigens des Trägers (9) an dem gedruckten Träger (3), einen Schritt des elektronischen Verbindens des elektrischen Verbindungsmittels des Trägers (9) mit der gedruckten Schaltung (3).

8. Verfahren nach einem oder mehreren der vorhergehenden Ansprüche, **dadurch gekennzeichnet, dass** dieses den Schritt des Anordnens der elektronischen Schaltung (2) innerhalb eines Schutzgehäuses (10) umfasst.

9. Batterie-Ladevorrichtung (1) für Fahrzeuge mit wenigstens einer elektronischen Schaltung (2), die an die Batterie eines Fahrzeugs angeschlossen werden kann und zum Laden der Batterie geeignet ist, wobei die elektronische Schaltung (2) wenigstens eine gedruckte Schaltung (3) und wenigstens eine mit der gedruckten Schaltung (3) elektronisch verbundene Wickelkomponente (5) umfasst,
- wobei die Wickelkomponente (5) an der gedruckten Schaltung (3) befestigt ist;
- wobei die elektronische Schaltung (2) wenigstens eine Schablone (6) umfasst, die an der gedruckten Schaltung (3) verankert ist, wobei die Schablone (6) wenigstens eine äußere Haltewand (7) aufweist, welche sich wenigstens teilweise um die Wickelkomponente (5) herum erstreckt;
- und wobei die elektronische Schaltung (2) wenigstens eine Schicht eines verfestigten warmhärtenden Materials (8) umfasst, welche den gesamten Bereich der gedruckten Schaltung (3) abdeckt, der in Übereinstimmung mit der gewickelten Komponente (5) durch die Außenwand (7) begrenzt ist, um die Wickelkomponente (5) auf der gedruckten Schaltung (3) zu blockieren.

10. Batterie-Ladevorrichtung (1) nach Anspruch 9, **dadurch gekennzeichnet, dass** die elektronische Schaltung (2) eine Mehrzahl von Wickelkomponenten umfasst, die an der gedruckten Schaltung (3) befestigt sind, und dadurch, dass die Außenwand (7) der Schablone (6) die Mehrzahl von Wickelkomponenten umgibt.

11. Batterie-Ladevorrichtung (1) nach einem oder mehreren der Ansprüche 9 und 10, **dadurch gekennzeichnet, dass** die gedruckte Schaltung (3) wenigstens einen Träger aus dielektrischem Material und/oder einen Träger aus Metall-Material umfasst.

12. Batterie-Ladevorrichtung (1) nach einem oder mehreren der Ansprüche 9 bis 11, **dadurch gekennzeichnet, dass** die elektronische Schaltung (2) wenigstens einen Träger (9) aus dielektrischem Material umfasst, wobei die Wickelkomponente (5) an dem Träger (9) befestigt ist und wobei der Träger (9) an der gedruckten Schaltung (3) befestigt ist.

13. Batterie-Ladevorrichtung (1) nach Anspruch 12, **dadurch gekennzeichnet, dass** der Träger (9) aus dielektrischem Material elektronische Verbindungsmittel zwischen der Wickelkomponente (5) und der gedruckten Schaltung (3) umfasst.

## Revendications

1. Procédé pour la fabrication de chargeurs de batterie pour véhicules, comprenant une étape de fabrication d'au moins un circuit électronique (2) apte à être connecté à la batterie d'un véhicule et apte à charger ladite batterie, ledit circuit électronique (2) ayant au moins un circuit imprimé (3) et au moins un composant bobiné (5) connecté électroniquement audit circuit imprimé (3), ladite étape de fabrication comprenant les étapes suivantes :
- fixer ledit composant bobiné (5) audit circuit imprimé (3) ;
- ancrer au moins un gabarit (6) audit circuit imprimé (3), ledit gabarit (6) ayant au moins une paroi de retenue extérieure (7) qui s'étend au moins partiellement autour dudit composant bobiné (5) ;
- déposer un matériau thermodurcissable (8) sur toute la surface dudit circuit imprimé (3) délimitée par ladite paroi extérieure (7) du gabarit (6), en correspondance avec ledit composant bobiné (5) ;
- solidifier ledit matériau thermodurcissable (8) pour bloquer ledit composant bobiné (5) sur ledit circuit imprimé (3).

2. Procédé selon la revendication 1, **caractérisé en ce que** ladite étape de fabrication comprend l'étape de fixer une pluralité de composants bobinés audit circuit imprimé (3) et **en ce que** ladite paroi extérieure (7) du gabarit (6) entoure ladite pluralité de composants bobinés.

3. Procédé selon l'une ou plusieurs des revendications précédentes, **caractérisé en ce que** ledit matériau thermodurcissable (8) est du type résine ou similaire.

4. Procédé selon l'une ou plusieurs des revendications précédentes, **caractérisé en ce que** ledit circuit imprimé (3) comprend au moins un support réalisé en matériau diélectrique.

5. Procédé selon l'une ou plusieurs des revendications précédentes, **caractérisé en ce que** ledit circuit imprimé (3) comprend au moins un support réalisé en matériau métallique.

6. Procédé selon l'une ou plusieurs des revendications précédentes, **caractérisé en ce que** ladite étape de fixation comprend les étapes suivantes :
- fixer ledit composant bobiné (5) à au moins un support (9) réalisé en matériau diélectrique ;
- fixer ledit support (9) audit circuit imprimé (3).

7. Procédé selon la revendication 6, **caractérisé en ce que** ledit support (9) réalisé en matériau diélectrique comprend des moyens électroniques de connexion entre ledit composant bobiné (5) et ledit circuit imprimé (3) et **en ce que** ladite étape de connexion comprend :
- après ladite étape de fixation dudit composant bobiné (5) audit support (9), une étape de connexion électronique dudit composant bobiné (5) auxdits moyens électroniques de connexion du support (9) ;
- après ladite étape de fixation dudit support (9) audit support imprimé (3), une étape de connexion électronique desdits moyens électroniques de connexion du support (9) audit circuit imprimé (3).

8. Procédé selon l'une ou plusieurs des revendications précédentes, **caractérisé en ce qu'**il comprend l'étape d'agencement dudit circuit électronique (2) à l'intérieur d'un boîtier de protection (10).

9. Chargeur de batterie (1) pour véhicules, comprenant au moins un circuit électronique (2) apte à être connecté à la batterie d'un véhicule et apte à charger ladite batterie, ledit circuit électronique (2) ayant au moins un circuit imprimé (3) et au moins un composant bobiné (5) connecté électroniquement audit circuit imprimé (3),
- ledit composant bobiné (5) est fixé audit circuit imprimé (3) ;
- ledit circuit électronique (2) comprend au moins un gabarit (6) ancré audit circuit imprimé (3), ledit gabarit (6) ayant au moins une paroi de retenue extérieure (7) qui s'étend au moins partiellement autour dudit composant bobiné (5) ;
- et ledit circuit électronique (2) comprend au moins une couche de matériau thermodurcissable solidifié (8) qui recouvre toute la surface dudit circuit imprimé (3) délimitée par ladite paroi extérieure (7) du gabarit (6), en correspondance avec ledit composant bobiné (5), pour bloquer ledit composant bobiné (5) sur ledit circuit imprimé (3).

10. Chargeur de batterie (1) selon la revendication 9, **caractérisé en ce que** ledit circuit électronique (2) comprend une pluralité de composants bobinés fixés audit circuit imprimé (3) et **en ce que** ladite paroi extérieure (7) du gabarit (6) entoure ladite pluralité de composants bobinés.

11. Chargeur de batterie (1) selon l'une ou plusieurs des revendications 9 et 10, **caractérisé en ce que** ledit circuit imprimé (3) comprend au moins un support réalisé en matériau diélectrique et/ou un support réalisé en matériau métallique.

12. Chargeur de batterie (1) selon l'une ou plusieurs des revendications de 9 à 11, **caractérisé en ce que** ledit circuit électronique (2) comprend au moins un support (9) réalisé en matériau diélectrique, ledit composant bobiné (5) étant fixé audit support (9) et ledit support (9) étant fixé audit circuit imprimé (3).

13. Chargeur de batterie (1) selon la revendication 12, **caractérisé en ce que** ledit support (9) réalisé en matériau diélectrique comprend des moyens électroniques de connexion entre ledit composant bobiné (5) et ledit circuit imprimé (3).
